# FASCICULE DE BREVET EUROPEEN

(11) **EP 0 586 770 B1**
(45) Date de publication et mention de la délivrance du brevet: **25.06.1997**
(21) Numéro de dépôt: 92810685.5
(22) Date de dépôt: 08.09.1992
(51) Int. Cl.: C25D 21/10

(54) **Porte-racks pour installations de traitement de surface par bains et procédé de fabrication**
Gestell für Vorrichtungen zur Oberflächenbehandlung mit Bädern sowie Herstellungsverfahren
Rack-support for surface treatment with baths and its manufacturing process

(43) Date de publication de la demande: 16.03.1994
(73) Titulaire: SUNTEC TRADING AG, 3280 Greng (CH)
(72) Inventeur: Naescher, Edmund-Anton, CH-1400 Yverdon-Les-Bains (CH); SCHOPFER, Pierre-André, 2023 Gorgier (CH)
(74) Mandataire: Savoye, Jean-Paul

(56) Documents cités:
- DE-U- 9 004 297
- DE-U- 9 011 675
- GB-A- 2 247 027

## Description

Les installations de traitement de surface par bains, et notamment les installations de galvanoplastie, sont généralement munies de supports placés de part et d'autre, sur les bords de la ou des cuves qui contiennent les bains. On pose sur ces supports des barres qui surplombent ainsi le bain. Des rateliers, ou, dans le langage du métier, des "racks", sont fixés à ces barres, directement ou par l'intermédiaire d'autres pièces. Les racks sont plongés dans le bain. Les pièces à traiter sont fixées sur les racks.

Le traitement de pièces présentant des trous est difficile, car il est nécessaire de faire pénétrer le liquide du bain de traitement dans les trous. Il faut donc en évacuer l'air et y faire pénétrer le liquide. Puis il est nécessaire de faire sortir le liquide de traitement avant de plonger la pièce à traiter dans un autre bain traitant.

Cette nécessité existe notamment dans le traitement galvanoplastique des circuits imprimés. En effet, on fabrique actuellement des circuits imprimés à plusieurs couches qui peuvent présenter, assez couramment, de vingt à trente couches. Les trous qui relient ces couches, et dont les parois doivent être recouvertes d'un revêtement conducteur pour relier électriquement entre elles les couches du circuit, sont de plus en plus profonds et étroits. Il peuvent aisément avoir une profondeur de cinq à six millimètres, alors que leur diamètre peut ne pas dépasser deux dixièmes de millimètres. Il va de soi qu'il est d'autant plus difficile de déposer un revêtement sur les parois d'un trou que la profondeur de ce trou et plus grande et son diamètre plus étroit.

Afin d'assurer une certaine circulation du liquide et de faciliter ainsi sa pénétration, une technique classique consiste à imprimer à l'ensemble de l'installation, c'est-à-dire à l'ensemble des cuves et des racks, un mouvement de balancement périodique. Un tel mouvement est cependant lent, du fait de l'inertie de l'installation.

Une technique plus récente, qui s'emploie d'ailleurs simultanément avec la précédente, consiste à placer un vibreur entre le bord de la cuve et le support sur lequel est posée la barre porte-racks : le support, généralement en forme de V, est fixé sur un ressort fixé lui-même sur le bord de la cuve, et le vibreur, qui est habituellement un dispositif à excentrique, est fixé d'un côté au bord de la cuve et de l'autre à la fourche du support. On obtient ainsi une vibration du porte-racks, et par conséquent des racks et des pièces à traiter qui sont fixées aux racks. La vibration provoque l'élimination des bulles et la pénétration du liquide dans les trous, pendant la phase de dépôt galvanique. Elle permet aussi l'évacuation du liquide des trous dans la phase de nettoyage.

Cette technique a cependant des limites : du fait que le vibreur est attaché à la cuve, toute l'installation vibre et il y a une déperdition considérable d'énergie. Seule une petite partie de l'énergie des vibrations est transmise aux pièces à traiter immergées. Du fait de l'inertie, la fréquence des vibrations ne peut pas être très élevée. Il est en outre nécessaire de placer au moins un vibreur sur chaque cuve. Il faut donc modifier assez considérablement les installations existantes pour appliquer cette technique.

Dans une technique améliorée, appliquée par exemple dans le modèle d'utilité allemand DE-U-9011675 SIEMENS et dans le brevet britannique GB-A-2247027 Hans Henig, le vibreur destiné à imprimer un vibration rapide aux pièces immergées est fixé ou peut être fixé, directement ou indirectement, sur la barre qui porte les racks. Dans le modèle d'utilité allemand No. DE-U-9011675 SIEMENS, la figure 2 montre une forme d'exécution dans laquelle le vibreur est placé sur le porte-racks lui-même, entre les points d'appui du porte-racks sur les supports qui le soutiennent. Une telle dispostion permet un vibrage sans déperdition d'énergie, à fréquence élevée, et évite la nécessité d'un vibreur sur chaque cuve. Elle permet l'utilisation des installations classiques sans modifications considérables.

Il est à noter toutefois que, dans les machines existantes, et notamment dans celles décrites ci-dessus, les vibreurs sont simplement ajoutés sur le porte-racks, qu'il s'agisse de vibreurs à balourd ou de vibreurs électromagnétiques.

Un objet de la présente invention est donc de fournir un porte-racks pour installations de traitement de surface, notamment de galvanoplastie, qui permette un vibrage à fréquence élevée sans déperdition d'énergie, et de donner aux vibrations une direction précise.

Un autre objet de l'invention est de fournir un procédé de traitement de surface, notamment galvanoplastique, des circuits imprimés, facilitant l'introduction du liquide traitant dans les trous des circuits.

L'invention est définie dans les revendications.

Dans le porte-racks selon l'invention, le vibreur est placé entre les points d'appui du porte-racks sur les supports qui le soutiennent lorsque les pièces à traiter sont immergées dans un bain de traitement; le porte-racks comprend au moins une première barre à laquelle sont attachés les racks, une deuxième barre à laquelle est fixée une première partie du vibreur et présentant au moins deux points d'appui permettant le posage au-dessus d'une cuve d'une installation de traitement de surface, et une troisième barre à laquelle sont fixées la première barre et une deuxième partie du vibreur qui vibre par rapport à la première partie du vibreur lorsque le vibreur fonctionne.

Dans une première forme d'exécution particulière, le porte-racks est caractérisé en ce que la première barre est placée au-dessous de la deuxième barre, et la deuxième barre au-dessous de la troisième barre, et en ce que la masse formée par la deuxième barre et la première partie du vibreur est largement supérieure à la masse de la première ou de la deuxième barre.

Dans une deuxième forme d'exécution, qui inclut la précédente, le porte-racks est caractérisé en ce que la première partie du vibreur comprend au moins une bobine électrique entourant un noyau magnétisable, en ce que la deuxième partie du vibreur comprend au moins un élément magnétisable placé face au noyau magnétisable, et en ce qu'au moins un élément élastique relie directement ou indirectement la première partie à la deuxième partie.

Dans une troisième forme d'exécution, qui reprend les deux premières, l'élément élastique est une lame de ressort.

Dans une forme d'exécution supplémentaire, qui peut s'appliquer aux quatre formes d'exécution précédemment décrites, le porte-racks est caractérisé en ce que le mouvement de vibration se fait dans une direction qui forme un angle aigu avec le plan vertical longitudinal du porte-racks.

Dans une forme d'exécution supplémentaire, l'angle aigu donné à la direction du mouvement de vibration par rapport au plan vertical longitudinal du porte-racks est obtenu par la fixation de biais de la lame de ressort sur les deux parties du vibreur par rapport au plan vertical longitudinal du porte-racks. Cette forme d'exécution peut s'appliquer, à chacune des cinq premières formes d'exécution décrites ci-dessus.

Une sixième forme d'exécution de l'invention consiste dans l'utilisation de chacune des formes d'exécution précédemment décrites dans une installation de galvanoplastie.

L'invention concerne en outre un procédé de traitement de surface de circuits imprimés à plusieurs couches par immersion dans un bain, comprenant une phase dans laquelle on fixe le ou les circuits imprimés à traiter à au moins un rack, et une phase dans laquelle on le ou les plonge dans le bain de traitement, caractérisé en ce que l'on donne au(x) circuit(s) imprimé(s) un mouvement vibratoire dont la direction forme un angle aigu avec le plan du ou des circuits imprimés.

Dans une première forme d'exécution particulière, le procédé de traitement de surface est caractérisé en ce que le traitement est galvanoplastique.

Le procédé de traitement de surface, dans sa forme générale, ou dans sa forme d'exécution particulière est applicable dans chacune des sept formes d'exécution du porte-racks selon l'invention décrite précédemment.

Les dessins représentent, à titre d'exemple, une forme d'exécution de l'invention.

La figure 1 est une coupe schématique d'une cuve d'une installation de traitement de surface avec un porte-racks selon l'invention posé sur les supports des bords de la cuve, avec des racks suspendus et des circuits imprimés plongés dans un bain traitant.

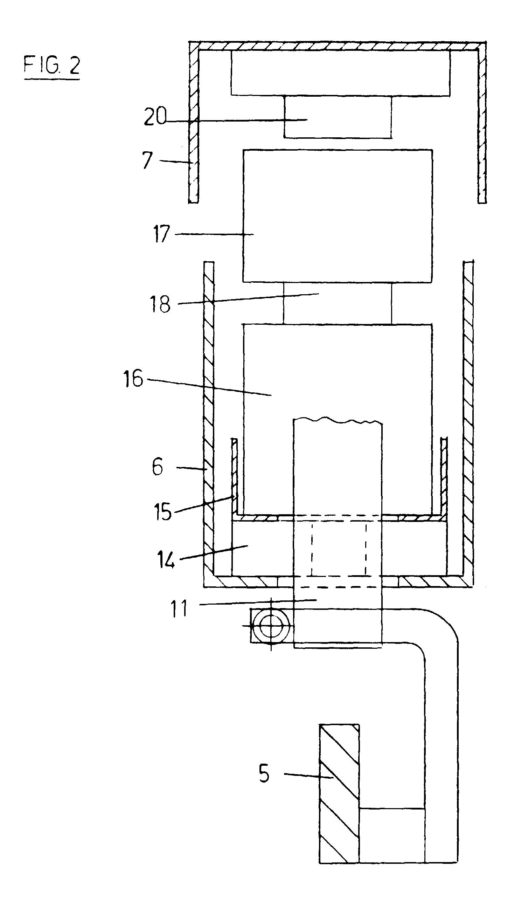

La figure 2 est une coupe transversale partielle d'un porte-racks selon l'invention, avec un vibreur,

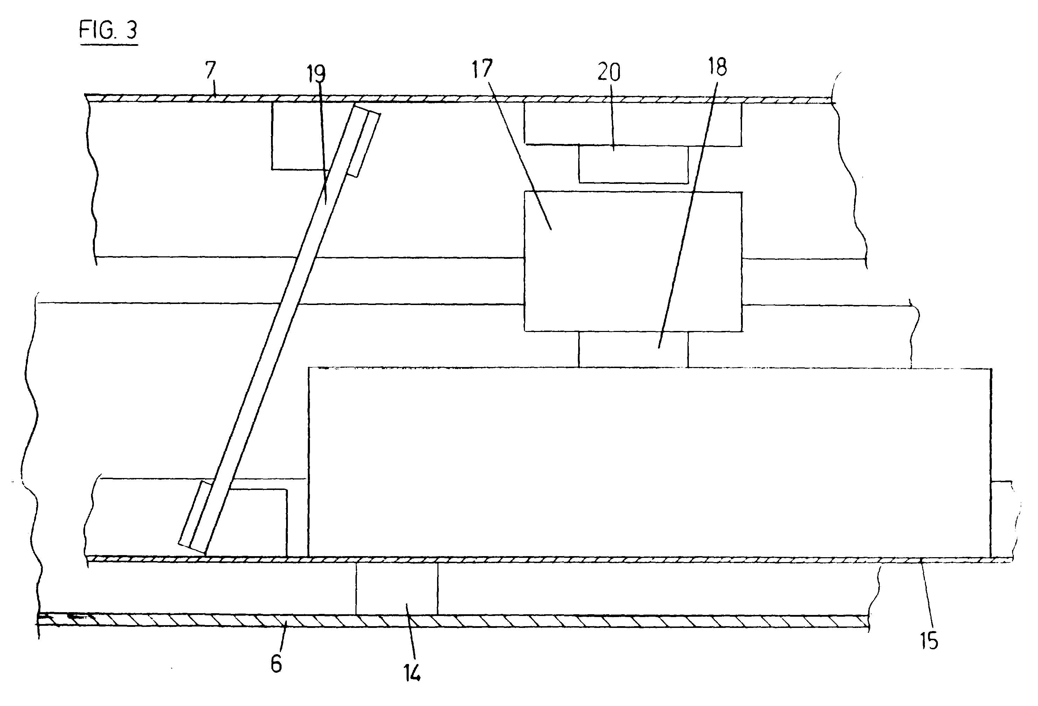

La figure 3 est une coupe longitudinale partielle d'un même porte-racks, avec un vibreur.

La figure 4 est une vue partielle en plan de la fixation d'une lame de vibreur dans une forme d'exécution particulière de l'invention.

La figure 5 est une vue en coupe partielle d'un circuit imprimé plongé dans un bain traitant et subissant un mouvement vibratoire oblique favorisant l'entrée du liquide dans un trou du circuit imprimé.

Dans la forme d'exécution représentée ici, le porte-racks comprend au moins une première barre 5 sur laquelle sont dixés les racks 10. Il pourrait y en avoir plusieurs. Cette première barre est une simple liste. Elle est suspendue à des tubes 11, qui traversent une deuxième barre 6 placée au-dessus de la première barre. Les trous permettant le passage des tubes 11 à travers la deuxième barre sont suffisamment larges pour éviter le contact entre les tubes et la deuxième barre. Les tubes sont fixés à une troisième barre 7 qui est au-dessus de la deuxième barre.

La deuxième barre 6, qui est la pièce maîtresse, est terminée à chaque bout par une liste verticale 12 qui porte les points d'appui 2. Ces points d'appui reposent sur des supports 3 placés sur les bords de la cuve 4. Les listes verticales 12 présentent, au-dessus des points d'appui 2, des ergots 13 qui permettent de soulever le porte-racks et de le transporter à une autre cuve. La deuxième barre a une section transversale en forme de U pour assurer sa rigidité. Sur le fond du U sont placés des silentblocs 14, sur lesquels est fixé un profil 15 qui soutient lui-même une masse 16 surmontée d'une bobine 17 qui entoure un noyau magnétisable 18. Des lignes électriques non représentées ici, ainsi que des moyens de moduler le courant, alimentent la bobine.

Une lame 19 de ressort est fixée par son extrémité inférieure au profil 15 et par son extrémité supérieure à la troisième barre 7. La lame est fixée obliquement par rapport à la verticale.

Sur la troisième barre est placé, en face du noyau magnétisable 18, un élément magnétisable 20. De préférence, la troisième barre est faite d'un matériau non magnétisable, comme l'aluminium.

Quant à la lame, elle est de préférence en matière plastique renforcée de fibres de verre.

Il va de soi que le passage d'un courant dans la bobine magnétise le noyau, et que le champ magnétique ainsi créé attire l'élément magnétisable 20, rapprochant ainsi la troisième barre de la deuxième. La lame plie, provoquant un mouvement correspondant de la troisième barre et par conséquent de la première barre qui en est solidaire, et des racks ainsi que des pièces à traiter qui sont plongées dans le liquide. L'interruption du passage du courant permet le mouvement inverse sous l'effet du redressement de la lame.

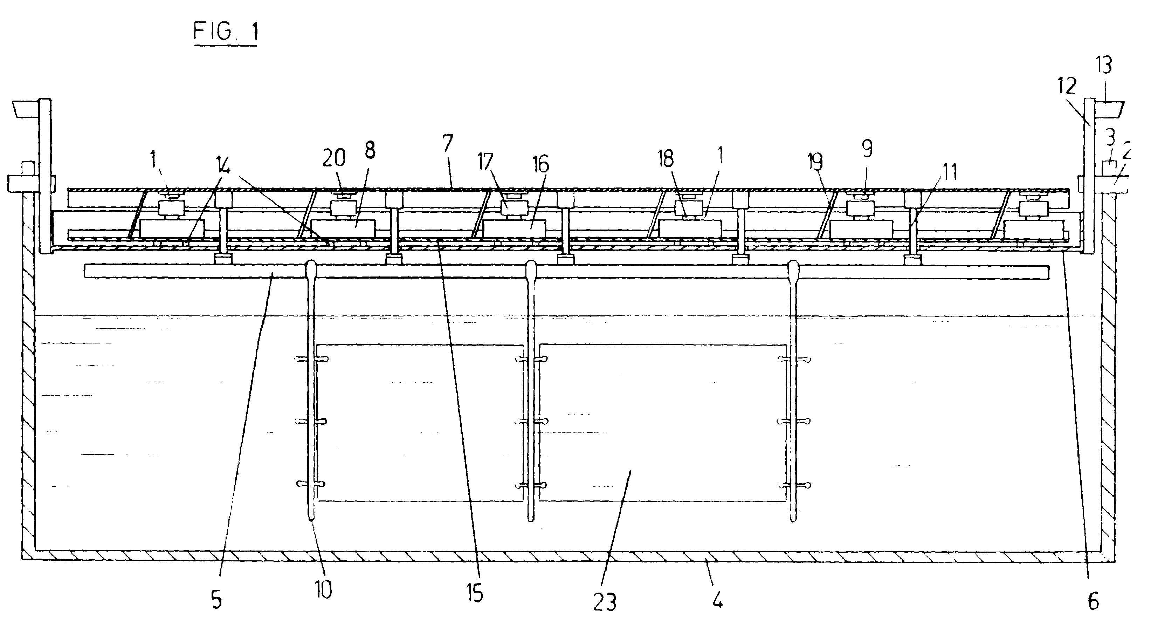

Dans la forme d'exécution de la figure 1, le porte-racks présente six vibreurs 1. Il va de soi qu'il peut y en avoir moins, ou éventuellement plus. Une particularité du porte-racks selon l'invention est que le vibreur 1 est placé sur le porte-racks lui-même, et qu'il n'est pas fixé à l'installation qui comprend la cuve et les supports. Il s'ensuit que seul le porte-racks (ainsi que les racks 10 et les pièces à traiter) vibre, mais non l'installation. Il s'ensuit une perte d'énergie nettement moindre. En outre, la masse en mouvement étant moindre, la fréquence peut être plus élevée. De préférence, le vibreur 1 est placé entre les points d'appui 2 du porte-racks qui sont posés sur les supports 3 de la cuve 4. Le vibreur étant proche des pièces à traiter, la distance ne produit pas non plus les pertes qui se produisent dans les installations actuellement connues. Enfin, le vibreur étant solidaire du porte-racks, il n'est pas nécessaire de placer un vibreur à chaque cuve : le porte-racks peut être transporté d'une cuve à l'autre avec le vibreur. La troisième barre 7 constitue elle-même une partie du vibreur, et elle est directement fixée à la deuxième barre 6 par l'intermédiaire des lames 19. Il est donc facile, en orientant les lames, de donner une direction déterminée à la vibration.

Les silentblocs 14 amortissent déjà une partie non négligeable des vibrations transmises aux supports 3 et à la cuve 4. Afin d'augmenter encore l'amortissement, il est indiqué de placer les supports 3 sur des ressorts, comme dans certaines installations existantes.

Dans le cas de pièces présentant des trous, comme des circuits imprimés, si le mouvement de vibration se fait dans une direction parallèle au plan du circuit imprimé 23, le liquide n'entre pas avec une grande force dans les trous. La présente invention permet d'augmenter cette force de pénétration en donnant à la direction 22 du mouvement vibratoire un angle aigu par rapport au plan du circuit imprimé 23 (un mouvement perpendiculaire est déjà donné par les oscillations déjà employées de manière classique et qu'il convient aussi d'employer dans le présent procédé). De la sorte, et comme le montre la figure 5, le flux 21 de liquide traitant frappe la paroi du trou 24 et tend à s'introduire dans celui-ci.

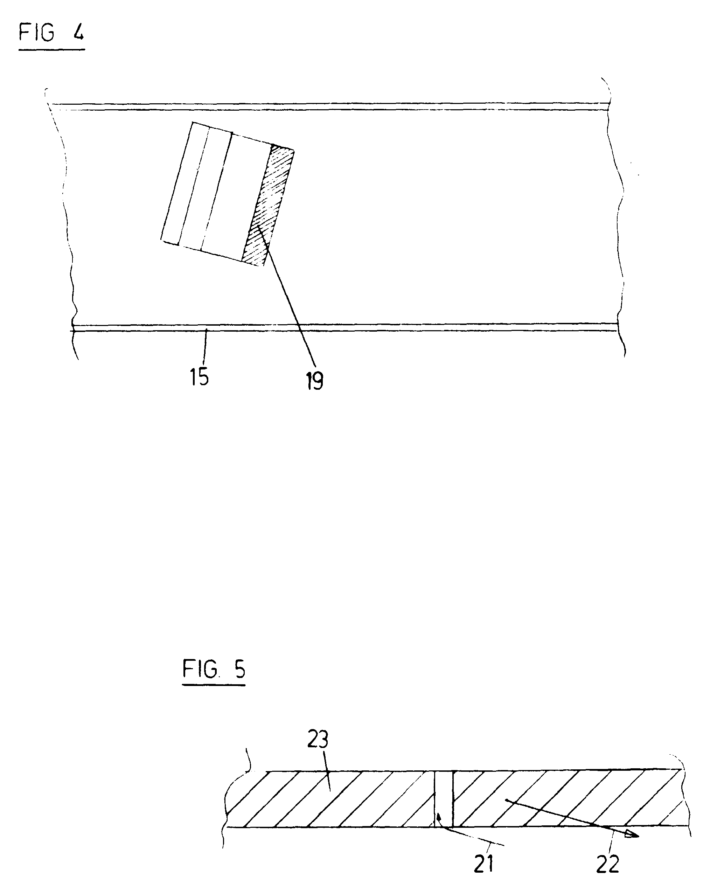

Pour obtenir un tel effet avec le porte-racks vibrant décrit plus haut, il suffit de fixer la lame 19 de biais par rapport au plan vertical longitudinal du porte-racks, comme le montre la figure 4.

Il va de soi que les divers éléments constitutifs du porte-racks, comme les barres, les lames, les bobines, les noyaux et éléments magnétisables, peuvent multipliés selon les besoins.

## Revendications

1. Porte-racks pour installations de traitement de surface par bains, muni d'au moins un vibreur (1) placé entre les points d'appui (2) du porte-racks sur les supports (3) qui soutiennent le porte-racks lorsque les pièces à traiter (23) sont immergées dans un bain de traitement, caractérisé en ce qu'il comprend au moins une première barre (5) à laquelle sont attachés les racks, une deuxième barre (6) à laquelle est fixée une première partie (8) du vibreur et présentant au moins deux points d'appui (2) permettant le posage au-dessus d'une cuve (4) d'une installation de traitement de surface, et une troisième barre (7) à laquelle sont fixées la première barre et une deuxième partie (9) du vibreur qui vibre par rapport à la première partie du vibreur lorsque le vibreur fonctionne.

2. Porte-racks selon la revendication 1, caractérisé en ce que la première barre est placée au-dessous de la deuxième barre, et la deuxième barre au-dessous de la troisième barre, et en ce que la masse formée par la deuxième barre et la première partie du vibreur est largement supérieure à la masse de la première ou de la deuxième barre.

3. Porte-racks selon l'une des revendications 1 ou 2, caractérisé en ce que la première partie du vibreur comprend au moins une bobine électrique (17) entourant un noyau magnétisable (18), en ce que la deuxième partie du vibreur comprend au moins un élément magnétisable (20) placé face au noyau magnétisable, et en ce qu'au moins un élément élastique (19) relie directement ou indirectement la première partie à la deuxième partie.

4. Porte-racks selon la revendication 3, caractérisé en ce que l'élément élastique (19) est une lame.

5. Porte-racks selon l'une des revendications 1 à 4, caractérisé en ce que le mouvement de vibration se fait dans une direction (22) qui forme un angle aigu avec le plan vertical longitudinal du porte-rack.

6. Porte-racks selon la revendication 5, caractérisé en ce que la lame (19) est fixée de biais sur les deux parties du vibreur par rapport au plan vertical longitudinal du porte-racks.

7. Utilisation d'un porte-racks selon l'une des revendications 1 à 6 dans une installation de galvanoplastie.

8. Procédé de traitement de surface de circuits imprimés (23) à plusieurs couches par immersion dans un bain, comprenant une phase dans laquelle on fixe le ou les circuits imprimés à traiter à au moins un rack, et une phase dans laquelle on le ou les plonge dans le bain de traitement, caractérisé en ce que l'on donne au(x) circuit(s) imprimé(s) un mouvement vibratoire dont la direction (22) forme un angle aigu avec le plan du ou des circuits imprimés.

9. Procédé de traitement de surface selon la revendication 8, caractérisé en ce que le traitement est galvanoplastique.

10. Utilisation d'un porte-racks selon l'une des revendications 1 à 7 dans un procédé selon l'une des revendications 8 ou 9.

## Patentansprüche

1. Rahmenträger für Vorrichtungen zur Oberflächenbehandlung durch Bäder, ausgestattet mit wenigstens einem Schwingungserzeuger (1), welcher zwischen Auflagepunkten (2) des Rahmenträgers auf Trägern (3) angeordnet ist, welche die Rahmenträger stützen, wenn die zu behandelnden Teile (23) in ein Behandlungsbad eingetaucht sind, dadurch gekennzeichnet, dass er wenigstens eine erste Schiene (5) umfasst, an welche die Träger angehängt sind, sowie eine zweite Schiene (6), an welcher ein erster Teil (8) des Schwingungserzeugers befestigt ist, und welche wenigstens zwei Auflagepunkte (2) aufweist, welche das Auflegen über einer Wanne (4) einer Vorrichtung zur Oberflächenbehandlung erlauben, sowie eine dritte Schiene (7), an welcher die erste Schiene und ein zweiter Teil (9) des Schwingungserzeugers befestigt sind, welcher im Bezug auf den ersten Teil des Schwingungserzeugers schwingt, wenn der Schwingungserzeuger in Betrieb ist.

2. Rahmenträger nach Anspruch 1, dadurch gekennzeichnet, dass die erste Schiene unterhalb der zweiten Schiene angeordnet ist, und die zweite Schiene unterhalb der dritten Schiene, und dass die Masse, welche durch die zweite Schiene und den ersten Teils des Schwingungserzeugers gebildet wird, sehr viel grösser ist als die Masse der ersten oder der zweiten Schiene.

3. Rahmenträger nach einem der Ansprüche 1 oder 2, dadurch gekennzeichnet, dass der erste Teil des Schwingungserzeugers wenigstens eine elektrische Spule (17) umfasst, welche einen magnetisierbaren Kern (18) umschliesst, und dass der zweite Teil des Schwingungserzeugers wenigstens ein magnetisierbares Element (20) umfasst, welches an der Stirnseite des magnetisierbaren Kerns angeordnet ist, und dass wenigstens ein elastisches Element (19) den ersten Teil mit dem zweiten Teil direkt oder indirekt verbindet.

4. Rahmenträger nach Anspruch 3, dadurch gekennzeichnet, dass das elastische Element (19) ein Plättchen ist.

5. Rahmenträger nach einem der Ansprüche 1 bis 4, dadurch gekennzeichnet, dass die Schwingungsbewegung in einer Richtung (22) erfolgt, welche mit der vertikalen Längsebene des Rahmenträgers einen spitzen Winkel bildet.

6. Rahmenträger nach Anspruch 5, dadurch gekennzeichnet, dass das Plättchen (19) schräg zu den beiden Teilen des Schwingungserzeugers im Bezug auf die vertikale Längsebene der Rahmenträger befestigt ist.

7. Verwendung der Rahmenträger nach einem der Ansprüche 1 bis 6 in einer Galvanisiervorrichtung.

8. Verfahren zur Behandung der Oberfläche von gedruckten Schaltungen (23) mit mehreren Schichten durch Eintauchen in ein Bad, umfassend eine Phase, in welcher ein oder mehrere zu behandelnde gedruckte Schaltungen an wenigstens einem Rahmen befestigt werden, und eine Phase, in welcher die gedruckte(n) Schaltung(en) in das Behandlungsbad eingetaucht wird (werden), dadurch gekennzeichnet, dass die gedruckte(n) Schaltung(en) in einer Schwingungsbewegung bewegt wird (werden), deren Richtung (22) einen spitzen Winkel mit der Ebene der gedruckten Schaltung(en) bildet.

9. Verfahren zur Behandlung der Oberfläche nach Anspruch 8, dadurch gekennzeichnet, dass die Behandlung galvanisch ist.

10. Verwendung eines Rahmenträgers nach einem der Ansprüche 1 bis 7 in einem Verfahren nach einem der Ansprüche 8 oder 9.

## Claims

1. Rack holder for surface treatment installations involving bath immersion, equipped with at least one vibrator (1) placed between the supporting points (2) of the rack holder on supports (3) which hold the rack holder when the parts to be treated (23) are immersed in a treatment bath, characterized in that it comprises at least a first bar (5) on to which the racks are attached, a second bar (6) on to which a first part (8) of the vibrator is fixed and having at least two supporting points (2) allowing a surface treatment installation to be fitted above a tank (4), and a third bar (7) on to which are fixed the first bar and a second part (9) of the vibrator which vibrates in relation to the first part of the vibrator when the vibrator is in operation.

2. Rack holder accordina to claim 1, characterized in that the first bar is placed under the second bar, and the second bar under the third bar, and in that the mass formed by the second bar and the first part of the vibrator is considerably superior to the mass of the first or second bar.

3. Rack holder according to one of the claims 1 or 2, characterized in that the first part of the vibrator comprises at least one electrical coil (17) wrapped around a magnetizable core (18), in that the second part of the vibrator comprises at least one magnetizable element (20) placed opposite the magnetizable core, and in that at least one elastic element (19) connects the first part directly or indirectly to the second part.

4. Rack holder according to claim 3, characterized in that the elastic element (19) is a blade.

5. Rack holder according to one of the claims 1 to 4, characterized in that the vibrating movement is produced in a direction (22) which forms an acute angle with the longitudinal vertical plane of the rack holder.

6. Rack holder according to claim 5, characterized in that the blade (19) is fixed at an angle on to the two parts of the vibrator in relation to the longitudinal vertical plane of the rack holder.

7. Use of a rack holder according to claims 1 to 6 in an electroplating installation.

8. Surface treatment process for multi-layer printed circuits (23) by means of immersion in a bath, comprising one phase in which the printed circuits to be treated are fixed on to at least one rack, and another phase in which it or they are dipped into the treatment bath, characterized in that the printed circuit or circuits are subjected to a vibrating movement whose direction (22) forms an acute angle with the plane of the printed circuit or circuits.

9. Surface treatment process according to claim 8, characterized in that the treatment in question is electroplating.

10. Use of a rack holder according to one of the claims 1 to 7 in a process according to one of the claims 8 or 9.
